# EUROPEAN PATENT SPECIFICATION

(11) **EP 0 592 190 B1**
(45) Date of publication and mention of the grant of the patent: **16.04.1997**
(21) Application number: 93307906.3
(22) Date of filing: 05.10.1993
(51) Int. Cl.: H03B 21/02

(54) **Local oscillator and its frequency switching method**
Überlagerungsoszillator und Frequenzschaltverfahren dazu
Oscillateur local et sa méthode de commutation de fréquence

(30) Priority: 05.10.1992 JP 265690/92; 25.11.1992 JP 314768/92
(43) Date of publication of application: 13.04.1994
(73) Proprietor: NEC CORPORATION, Tokyo (JP)
(72) Inventor: Sasaki, Yutaka, Minato-ku, Tokyo (JP)
(74) Representative: Moir, Michael Christopher

(56) References cited:
- DE-A- 3 133 547
- GB-A- 2 218 870
- PATENT ABSTRACTS OF JAPAN vol. 10, no. 87 (E-393)(2144) 5 April 1986 & JP-A-60 229 535 (MATSUSHITA DENKI SANGYO K.K.)

## Description

### BACKGROUND OF THE INVENTION

### 1. Field of the Invention

The present invention relates to a local oscillator for radio-frequency ( RF ) communication systems and a frequency switching method of the oscillator, and more particularly, to a local oscillator for RF communication systems with frequency generators each of which generates a plurality of frequencies different from each other, and a frequency switching method of the oscillator, as taught, for example, by GB-A-2.218.870.

### 2. Description of the Prior Art

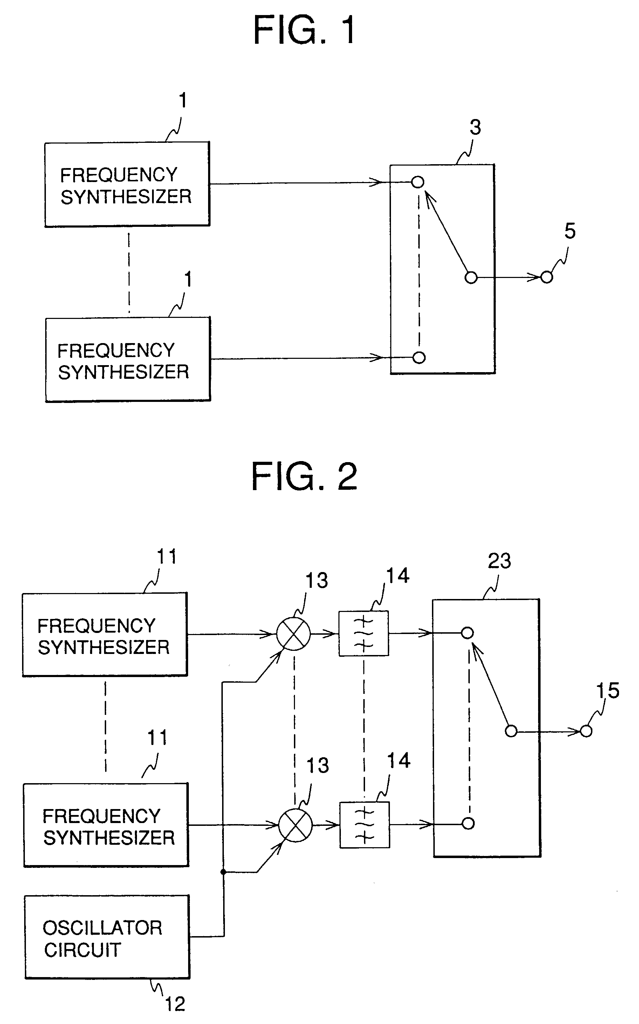

Fig. 1 is a functional block diagram for showing a frequency switching method of a conventional local oscillator of this sort.

In Fig. 1, there are provided with phase-locked loop (PLL) frequency synthesizers 1, each of which generates a plurality of frequencies from a single reference frequency, and a switch circuit 2 which selects one of local signals with the respective frequencies to send it to an output terminal 5. Each of the synthesizers 1 sends one of the frequencies generated to the switch circuit 3, and the frequencies sent from all the PLL synthesizers 1 are different from each other and belong to the same band of frequencies. The switch circuit 3 is generally composed of pin diodes for high-speed switching.

With the conventional frequency switching method, the circuit configuration of the local oscillator is simple, however, there are the following problems: A first problem is that all the synthesizers 1 operate simultaneously and isolation between input and output ends of the switch circuit 3 is not enough for such the frequencies, so that the frequencies not selected by the switch circuit 3 are sent to the output terminal 5 as spurious components.

The reason is that the unwanted or spurious frequencies are easy to be sent to the output terminal 5 at such high frequencies since the pin diode used in the switch circuit 3 carry out its switching operation by changing the electric resistance between its input and output ends and the isolation characteristic between these ends becomes degraded as its input frequency becomes higher.

Since all the frequencies generated by the respective synthesizers 1 belong to the same band of frequencies, it is not possible to remove the spurious components by using ordinary elements such as bandpass filters. As a result, in the case of the specification about the spurious components being strict, the conventional frequency switching method shown in Fig. 1 is difficult to be applied to the local oscillator of the sort.

To solve the problem about the spurious components, a sort of pin diodes providing sufficient isolation between their input and output ends at such the high frequencies may be employed in the switch circuit 3. However, such pin diodes are very expensive, resulting in high fabrication costs.

The second problem of the above-mentioned conventional method is that whenever the local frequencies to be outputted are changed by the switch circuit 3, the loads of the respective synthesizers 1 vary momentarily to cause fluctuation of the output frequencies from the synthesizers 1. As a result, the frequency switching operation is not finished until the time the fluctuation of the frequencies is disappeared. This means that the switching time is made long, or a quick switching operation cannot be given.

Fig. 2 is a block diagram for showing another conventional frequency switching method of a local oscillator of the sort, in which PLL frequency synthesizers 11, a fixed-frequency oscillator circuit 12, frequency mixers circuits 13, bandpass filters 14 and a switch circuit 23 are provided.

Each of the PLL frequency synthesizers 11 generates first signals with different frequencies belonging to the same band of frequencies and outputs one of them to the corresponding mixer circuit 13. The oscillator circuit 12 generates a second signal with a single, fixed frequency and outputs it to all the mixer circuits 13.

The frequencies from the synthesizers 11 and the fixed frequency from the oscillator 12 are in the following relationship: The sums or differences between each of the frequencies from the synthesizers 11 and the fixed frequency from the oscillator 12 are equal to desired local frequencies, respectively.

Each of the mixer circuits 13 mixes in frequency the first signal from the corresponding synthesizer 11 and the second signal from the oscillator circuit 12 to send it to the corresponding bandpass filter 14, resulting in a signal with the sum and difference of the frequencies from the corresponding synthesizer 11 and the oscillator circuit 12.

Each of the filters 14 removes a component with an undesired frequency, for example, the sum frequency, from the output signal of the corresponding mixer circuit 13 and transmits a component with a desired frequency, for example, the difference frequency, to the switch circuit 23. The spurious components from the mixer circuits 13 are removed by the corresponding filters 14, respectively.

The switch circuit 23 selects one of the output signals with the different frequencies from the bandpass filters 14 and send it to the output terminal 15 as a desired local signal, similar, to the case as shown in Fig. 1.

Thus, with the conventional method shown in Fig. 2, the signals with the desired frequencies are sent to the switch circuit 23 after their spurious components being removed, so that the first problem can be solved. In addition, since the switch circuit 23 is electrically connected to the frequency synthesizers 11 through the corresponding frequency mixer circuits 13 and bandpass filters 14, respectively, the loads of synthesizers 11 do not vary momentarily whenever the local frequency is changed and as a result, the fluctuation of the local frequencies taken out from the output end 15 can be cancelled. This means that the above-mentioned second problem can be also solved.

Yet, with the method shown in Fig. 2, in the case the input frequencies are higher and its specification about the spurious components is strict, the above-mentioned first problem about the spurious components remains unsolved due to insufficient isolation between the input and output ends of the switch circuit 23.

### SUMMARY OF THE INVENTION

Accordingly, an object of at least the preferred embodiments of the present invention is to provide a local oscillator and its frequency switching method in which a local signal is produced with less spurious components than the prior art with low fabrication cost and a simple circuit configuration.

A local oscillator according to a first aspect of the present invention comprises frequency generators for generating signals, said signals being different in frequency from each other;
combining means for combining signals with each other to generate a single output signal; and
a filter for selecting a component from said single output signal from said combining means thereby obtaining a desired local signal at an output end of said filter;
characterised in that said oscillator further comprises:
frequency dividers each respectively connected to a corresponding frequency generator and receiving an output signal from said corresponding frequency generator;
each of said frequency dividers having an active operation mode and an inactive operation mode, and in said active operation mode, dividing in frequency said output signal from said corresponding frequency generator by a divide ratio n (n is integer of two or more) to output a resulting frequency-divided signal, and in said inactive operation mode, outputting said output signal without division;
said oscillator further comprising control means for controlling said frequency dividers so that one of said frequency dividers is in said active operation mode and the or each of the others is in said inactive mode;
said combining means combining signals outputted from all of said frequency dividers with each other to generate said single output signal; and
said filter selecting a component with a divided frequency from said single output signal to obtain said desired local signal.

With the local oscillator of the first aspect, the frequency dividers respectively connected to the corresponding frequency generators are controlled so that one of the divider is selected to be in the active mode, thereby dividing the output frequency from the corresponding frequency generator. Then, the filter transmits the component with the frequency obtained through division and stops the rest obtained without division. As a result, the component selected by the filter is taken out as the local signal.

Since the other component or components of the output signal from the combining means are obtained without frequency division, they do not fall within the passband of the filter, and can be removed by the filter.

As a result, the local signal containing less spurious components than the prior art can be obtained.

In addition, since expensive pin diodes are not required to be employed, the fabrication cost of the local oscillator is made low and since complicated circuits are not contained, the circuit configuration is also made simple.

In a preferred embodiment, frequency multipliers are provided between the frequency dividers and the combining means, respectively. The multipliers multiply in frequency the respective output signals from the frequency dividers by m and send them to the combining means, where m is integer of two or more.

In another preferred embodiment, a frequency multiplier is provided between the combining means and the filter. The multiplier multiplies in frequency the output signals from the combining means by m and sends them to the filter.

A local oscillator according to a second aspect of the present invention comprises:
an oscillator generating a first signal with a fixed frequency of k times a given frequency, where k is an integer of two or more;
frequency generators for generating second signals, said second signals being different in frequency from each other;
frequency mixers;
filters respectively connected to said frequency mixers, each of which selects a components with a desired local frequency from an output signal of a corresponding one of said frequency mixers; and
an output terminal connected to all of said filters;
characterised in that the oscillator further comprises:
frequency dividers respectively connected to said oscillator, each of said frequency dividers receiving said first signal from said oscillator and dividing in frequency said first signal by a divide ratio of k;
control means for controlling said frequency dividers so that one of said frequency dividers is in operation and the or each of the remainder is out of operation;
frequency mixers each of which mixes in frequency an output signal from a corresponding one of said frequency dividers with said second signal from a corresponding one of said frequency generators;
and wherein said component with said desired local frequency is derived through the one of said filters corresponding to the operating one of said frequency dividers.

With the local oscillator of the second aspect, the first signal with the fixed frequency of k times as much as the given frequency, which is generated by the oscillator, is distributed to all the frequency dividers and divided in frequency by k there. The frequency dividers are so controlled that one of the dividers corresponding to the local frequency required is in operation, and its output signal thus divided by k in frequency is frequency-mixed with the second signal from the corresponding one of generators in the corresponding mixer.

Since the rest of the dividers are not in operation, the spurious components which are sent to the rest of the mixers have frequencies of k times as much as those to be mixed. Then, the frequencies of the spurious components do not belong to the passbands of the filters, respectively. Therefore, the spurious components can be removed by the filters, resulting in the local signal containing less spurious components than the prior art.

In addition, similar to that of the first aspect, the fabrication cost of the local oscillator is low and the circuit configuration is also simple.

According to a third aspect of the present invention, a frequency switching method of a local oscillator is provided comprising the steps of:
generating signals different in frequency by using frequency generators;
and characterised by further comprising the steps of
dividing in frequency one of said signals by a divide ratio n (n is an integer of two or more) by controlling frequency dividers respectively connected to said frequency generators so that one of said frequency dividers is in an active operation mode, thereby outputting a resulting frequency-divided signal and the or each of the others is in an inactive operation mode, thereby outputting one or more output signals without division;
combining said output signal from one of said frequency dividers which is in an active operation mode and said output signal or output signals from the or each of the remainder of said frequency dividers which is in an inactive operation mode with each other, thereby generating a single output signal; and
selecting by using a filter a component with a frequency obtained through said dividing step from said single output signal of said combining means as a local signal.

In a preferred embodiment, the respective output signals from the frequency dividers are multiplied in frequency by m to be combined, where m is integer of two or more by using frequency multipliers.

In another preferred embodiment, the single output signal combined is multiplied in frequency by m to be sent to the filter.

With the method of the third aspect, the same effects as those of the first aspect can be obtained.

According to a fourth aspect of the present invention, a frequency switching method for a local oscillator is provided, comprising the steps of:
generating a first signal with a fixed frequency of k times a given frequency by using an oscillator, where k is an integer of two or more;
generating second signals with different frequencies by using frequency generators;
characterised by further comprising the steps of:
dividing in frequency said first signal by a divide ratio k by using frequency dividers, said frequency dividers being connected to said oscillator and being controlled so that one of said frequency dividers is in operation thereby outputting a frequency divider signal and the or each of the remainder is out of operation, thereby outputting said first signal without division;
mixing in frequency by using frequency mixers said output signals from said frequency dividers with said second signals from said corresponding frequency generators, respectively; and
selecting by using filters a component with a desired local frequency from said respective output signals of said frequency mixers, said filters being respectively connected to said frequency mixers;
wherein said component with said desired local frequency is derived through one of said filters corresponding to the operating one of said frequency dividers.

With the method of the fourth aspect, the same effects as those of the second aspect can be obtained.

### BRIEF DESCRIPTION OF THE DRAWINGS

Fig. 1 is a functional block diagram of a conventional local oscillator.

Fig. 2 is a functional block diagram of another conventional local oscillator.

Fig. 3 is a functional block diagram of a local oscillator according to a first embodiment of the present invention.

Fig. 4 is a functional block diagram of a local oscillator according to a second embodiment of the present invention.

Fig. 5 is a functional block diagram of a local oscillator according to a third embodiment of the present invention.

Fig. 6 is a functional block diagram of a local oscillator according to a fourth embodiment of the present invention.

### DETAILED DESCRIPTION OF THE PREFERRED EMBODIMENTS

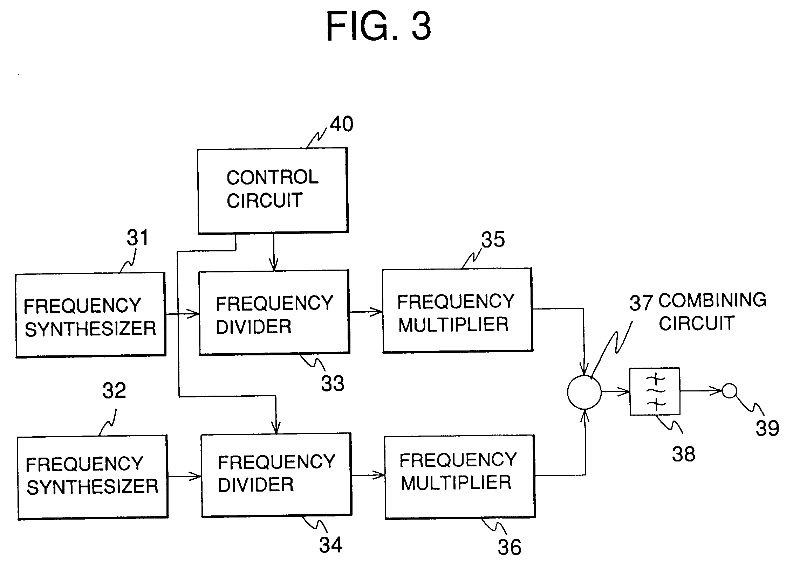

Preferred embodiments of the present invention will be described below referring to Figs. 3 to 6.

### [First embodiment]

As shown in Fig. 3, a local oscillator for an RF communication system according to a first embodiment of the present invention is composed of first and second PLL frequency synthesizers 31 and 32, first and second frequency dividers 33 and 34, a control circuit 40 for controlling the first and second frequency dividers 33 and 34, frequency multipliers 35 and 36, a combining circuit 37 and a bandpass filter 38.

The first PLL frequency synthesizer 31 generates a signal with a variable frequency (n/m)f₁ which is (n/m) times in value as much as a frequency f₁ to send it to the first frequency divider 33, where n ≠ m and n and m are integers of two (2) or more, respectively. The second PLL frequency synthesizer 32 generates a signal with a variable frequency (n/m)f₂ which is (n/m) times in value as much as a frequency f₂ to send it to the second frequency divider 34. These frequencies f₁ and f₂ are different in value from each other and belong to the same band of frequencies.

The first frequency divider 33 receives an output signal with a frequency (n/m)f₁ from the first synthesizer 31 and divides it in frequency by a divide ratio n in an active operation mode; then sends an output signal with a frequency (1/m)f₁ thus obtained to the first frequency multiplier 35. Similarly, the second frequency divider 34 receives an output signal with a frequency (1/m)f₂ from the second synthesizer 32 and divides it in frequency by a divide ratio n in an active operation mode; then sends an output signal with a frequency (1/m)f₂ thus obtained to the second frequency multiplier 36.

In an inactive operation mode, the first and second frequency dividers 33 and 34 receive the output signals from the first and second synthesizers 31 and 32, and then send them to the first and second frequency multipliers 35 and 36 without frequency division or change, respectively. Therefore, in the inactive operation mode, the output signals from the first and second frequency dividers 33 and 34 have frequencies (n/m)f₁ and (n/m)f₂, respectively.

The control circuit 40 controls the frequency dividers 33 and 34 so that one of the dividers 33 and 34 is in the active operation mode and the other is in the inactive one.

The first frequency multiplier 35 receives the output signal from the first divider 33 and multiplies it in frequency by a multiplication ratio m, then sends an output signal to the combining circuit 37. Similarly, the second frequency multiplier 36 receives the output signal from the second divider 34 and multiplies it in frequency by a multiplication ratio m, then sends an output signal to the combining circuit 37. Therefore, the output signal from the first frequency multiplier 35 has a frequency f₁ or nf₁, and the output signal from the second frequency multiplier 36 has a frequency f₂ or nf₂.

The combining circuit 37 receives the output signals from the first and second multipliers 35 and 36 and combines them to generate a single output signal containing the frequency components of the both output signals, and then sends it to the bandpass filter 38.

Since the first and second frequency dividers 33 and 34 are controlled by the control circuit 40 so that one of the dividers 33 and 34 is in the active operation mode and the other is in the inactive one, the output signal from the combining circuit 37 contains components with the frequencies f₁ and nf₂ in one case, and those of with the frequencies f₂ and nf₁ in another case.

The bandpass filter 38 selectively transmits the components of the output signal with the frequencies f₁ and f₂, and stops the components thereof with the frequencies nf₁ and nf₂. Since n is an integer of two (2) or more, such a setup is possible practically. Then, the component with the frequency f₁ or f₂ thus transmitted is selectively sent to an output terminal 39 as a local signal with a desired frequency.

Preferably, cut-off frequencies of the bandpass filter 38 is set up as follows:

In the case of n < m, the upper cut-off frequency is so set that signal components with the frequencies of (n/m)f₁ or less and (n/m)f₂ or less are stopped, and the lower cut-off frequency is so set that those with the frequencies of (2n/m)f₁ or more and (2n/m)f₂ or more are stopped. For example, if n = 2 and m = 3, signal components with the frequencies of (2/3)f₁ or less and (2/3)f₂ or less are stopped and those with the frequencies of (4/3)f₁ or more and (4/3)f₂ or more are stopped.

In the case of n > m, the upper cut-off frequency is so set that signal components with the frequencies of (n/m)f₁ or more and (n/m)f₂ or more are stopped. The lower cut-off frequency is not required to be set; then, a low-pass filter may be used.

Next, a frequency switching method of the local oscillator with the above-mentioned configuration is described below.

When a local signal with the frequency f₁ is taken out from the output terminal 39, the first frequency divider 33 is controlled to be put into the active operation mode and the second frequency divider 34 is into the inactive one.

The signal with the frequency (n/m)f₁ generated in the first frequency synthesizer 31 is sent to the first frequency divider 33 and is divided in frequency by n to be sent to the first frequency multiplier 35. The output signal from the first divider 33 has the frequency (1/m)f₁.

The signal with the frequency (n/m)f₂ generated in the second frequency synthesizer 32 is sent to the second frequency divider 34 and is sent to the second frequency multiplier 36 without frequency division. Therefore, the output signal from the second divider 33 has the frequency (n/m)f₂.

The first frequency multiplier 35 multiplies in frequency the output signal from the first frequency divider 33. Then, an output signal with the frequency f₁ from the multiplier 35 is sent to the combining circuit 37. Similarly, the second frequency multiplier 36 multiplies in frequency the output signal from the second frequency divider 34. Then, an output signal with the frequency nf₂ from the multiplier 36 is sent to the combining circuit 37.

The output signals from the first and second multipliers 35 and 36 are combined with each other to form a single output signal containing the components with the frequencies f₁ and nf₂ in the combining circuit 37.

As mentioned above, the bandpass filter 38 only transmits the components with the frequency f₁ and f₂, so that in this case, only the signal component with the frequency f₁ is selected to be transmitted to the output terminal 39. Thus, a local signal with the frequency f₁ desired can be obtained.

A local signal with the frequency f₂ can be taken out in the same sequence. In the case, the second frequency divider 34 is put into the active operation mode and the first frequency divider 33 is put into the inactive one by the control circuit 40.

The signal with the frequency (n/m)f₁ is sent to the first frequency divider 33 and is sent to the first frequency multiplier 35 without frequency multiplication. The output signal from the first divider 33 has the frequency (n/m)f₁.

The signal with the frequency (n/m)f₂ is sent to the second frequency divider 34 and divided in frequency by n to be sent to the second frequency multiplier 36. The output signal from the second divider 33 has the frequency (1/m)f₂.

The output signal with the frequency (n/m)f₁ from the first divider 33 is multiplied in frequency by m in the first multiplier 35 to be sent to the combining circuit 37. The output signal from the first multiplier 35 has the frequency nf₁.

Similarly, the output signal with the frequency (1/m)f₁ from the second divider 34 is multiplied in frequency by m in the second multiplier 36 to be sent to the combining circuit 37. The output signal of the second multiplier 36 has the frequency nf₂.

The output signals from the first and second multipliers 35 and 36 are combined with each other to form a single output signal containing the components with the frequencies nf₁ and f₂ in the combining circuit 37.

Only the signal component with the frequency f₂ is selected to be transmitted to the output terminal 39 by the bandpass filter 38. Thus, a local signal with the frequency f₂ desired can be obtained.

As described above, with the frequency switching method of the first embodiment, the first and second frequency dividers 33 and 34 are controlled so that one of the dividers 33 and 34 is put in the active operation mode, thereby obtaining the combined output signal with the component of the frequencies nf₁ and f₂ or that of the frequencies nf₂ and f₁. Then, the component of the frequencies f₁ or f₂ is selected by the filter 38 to be sent to the output terminal 39.

As a result, the local frequency can be switched by changing the operation modes of the first and second frequency dividers 33 and 34.

Since the unselect component has the frequency nf₁ or nf₂, the spurious component, generated in the combining circuit 37 has the same frequency nf₁ or nf₂; thus the spurious component can be removed by the filter 38. This means that the local frequencies with less spurious component than the prior art can be obtained.

In addition, since expensive pin diodes are not required to be employed as a switch circuit and complicated circuits are not contained, the fabrication cost of the local oscillator is low and the circuit configuration thereof is simple.

### [Second embodiment]

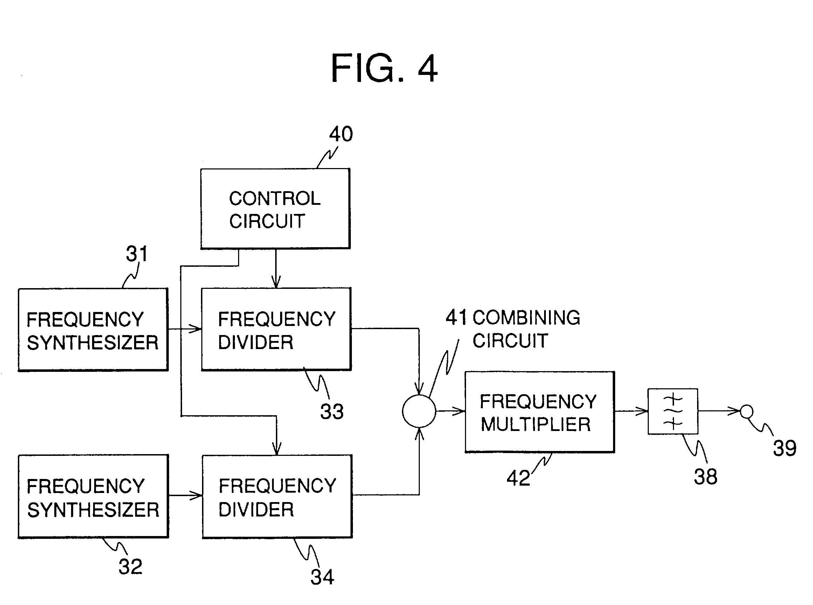

A local oscillator for an RF communication system according to a second embodiment is shown in Fig. 4. The local oscillator of the second embodiment is the same in configuration as that of the first embodiment except that the output signals from the second frequency dividers 33 and 34 are combined with each other to form a single output signal prior to frequency multiplication and then the signal thus obtained is multiplied in frequency.

Therefore, for the sake of simplification of explanation, the same reference numbers as those in Fig. 3 are attached to the corresponding elements in Fig. 4, and description about them is omitted.

In Fig. 4, as stated above in the first embodiment, the first and second frequency divider 33 and 34 divide in frequency by the given divide ratio n their input signals in the active operation mode, and do not divide them in the inactive operation mode.

A combining circuit 41 combines the output signals from the first and second frequency dividers 33 and 34 with each other to form a single output signal including the components with their both frequencies; then the output signal combined is sent to a frequency multiplier 42.

The first and second frequency dividers 33 and 34 are so controlled that one of them is in the active operation mode and the other is in the inactive one, so that the signal from the combining circuit 41 includes the components with the frequencies (1/m)f₁ and (n/m)f₂ in one case, and with those (n/m)f₁ and (1/m)f₂ in another case.

The frequency multiplier 42 receives the output signal from the combining circuit 41 and multiplies it in frequency by m to send a signal thus obtained by frequency multiplication to the bandpass filter 38. Therefore, the output signal from the multiplier 42 includes the components with the frequencies f₁ and nf₂ in one case, and with those nf₁ and f₂ in another case.

The bandpass filter 38 has a function that the components with the frequencies f₁ and f₂ are transmitted and those nf₁ and nf₂ are stopped, so that the output signal from the filter 38 includes the component with the frequency f₁ or f₂, which is sent to the output terminal 39 as a desired local signal.

Next, a frequency switching method of the local oscillator of the second embodiment is explained.

When a local signal with the frequency f₁ is taken out from the output terminal 39, the first frequency divider 33 is put into the active operation mode and the second frequency divider 34 is put into the inactive one by the control circuit 40.

The signal with the frequency (n/m)f₁ from the first frequency synthesizer 31 is sent to the first frequency divider 33 and is divided by n to be sent to the combining circuit 41. The output signal from the first divider 33 has the frequency (1/m)f₁. On the other hand, the signal with the frequency (n/m)f₂ from the second frequency synthesizer 32 is sent to the second frequency divider 34 and is sent to the combining circuit 41 without frequency division. The output signal from the second divider 33 has the same frequency (n/m)f₂ as that in the first synthesizer 31.

The output signals from the first and second dividers 33 and 34 are combined with each other to form the single output signal containing the components with the frequencies (1/m)f₁ and (m/n)f₂ in the combining circuit 37. The signal thus obtained through combination is then sent to the frequency multiplier 42 to be multiplied in frequency by m, resulting in the output signal with the frequencies f₁ and nf₂. The output signal thus obtained is then sent to the bandpass filter 38.

As the bandpass filter 38 only transmits the components with the frequency f₁ and f₂, so that only the signal component with the frequency f₁ is selected to be transmitted to the output terminal 39. Thus, a local signal with the frequency f₁ can be obtained.

A local signal with the frequency f₂ can be taken out in the same sequence. In the case, the first frequency divider 33 is put into the active operation mode and the second frequency divider 34 is put into the inactive one.

In the combining circuit 41, the output signals with the frequencies (n/m)f₁ and (1/m)f₂ from the first and second dividers 33 and 34 are combined with each other to form a single output signal containing the both components.

The output signal with the frequencies (n/m)f₁ and (1/m)f₂ from the combining circuit 41 is multiplied in frequency by m in the multiplier 42 to be sent to the bandpass filter 38. The output signal from the multiplier 42 has the frequencies nf₁ and f₂.

In the bandpass filter 38, only the signal component with the frequency f₂ is selected to be transmitted to the output terminal 39. Thus, a local signal with the frequency f₂ can be obtained.

With the local oscillator and its frequency switching method of the second embodiment, the same effects as those in the first embodiment can be obtained. Besides, there is an additional advantage that a circuit configuration of the local oscillator is simpler than that of the first embodiment since only one frequency multiplier is required.

### [Third Embodiment]

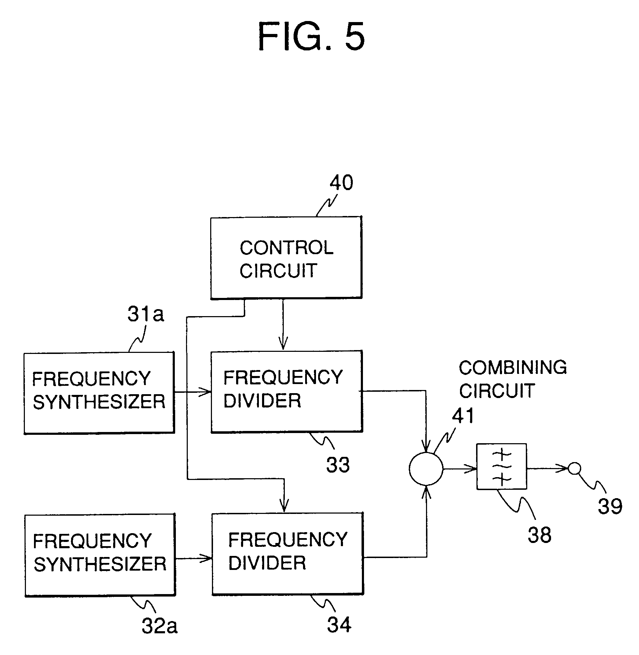

Fig. 5 shows a local oscillator for an RF communication system according to a third embodiment of the present invention. This oscillator is the same as those of the first and second embodiments except that no frequency multiplier is provided, and equivalent to those of the first and second embodiments in which m = 1. Therefore, for the sake of simplification of explanation, the same reference numbers as those in Fig. 3 or 4 are attached to the corresponding elements in Fig. 5, and description about them is omitted.

In Fig. 5, a first PLL frequency synthesizer 31a generates a signal with a variable frequency nf₁ which is n times as much as a frequency f₁ to send it to the first frequency divider 33. A second PLL frequency synthesizer 32a generates a signal with a variable frequency nf₂ which is n times as much as a frequency f₂ to send it to the second frequency divider 34.

The first frequency divider 33 divides in frequency by the divide ratio n the output signal with the frequency nf₁ from the first synthesizer 31a to generates an output signal with the frequency f₁ in the active operation mode. In the inactive operation mode, the divider 33 does not carry out the operation of frequency division, and the output signal with the frequency nf₁ is sent to the combining circuit 41 without frequency change.

Similarly, the second frequency divider 34 divides in frequency by the divide ratio n the output signal with the frequency nf₂ from the second synthesizer 32a to generate an output signal with the frequency f₂ in the active operation mode. In the inactive operation mode, the divider 34 does not carry out the operation of frequency division, and the output signal with the frequency nf₂ is sent to the combining circuit 41 without frequency change.

The first and second frequency dividers 33 and 34 are so controlled that one of them is in the active operation mode and the other is in the inactive one, similar to the first and second embodiments.

A combining circuit 41 combines the output signals from the first and second frequency dividers 33 and 34 with each other to form a single output signal including the components with their both frequencies. Then, the output signal thus combined is sent to the bandpass filter 41.

The first and second frequency dividers 33 and 34 are so controlled that one of them is in the active operation mode and the other is in the active one, so that the output signal from the combining circuit 41 has the components with the frequency f₁ and nf₂ in one case, and with those nf₁ and f₂ in another case.

In the bandpass filter 38, the component with the frequency f₁ is selectively transmitted to the output terminal 39 as a local signal in one case. In another case, the component with the frequency f₂ is selectively transmitted to the output terminal 39 as a local signal.

A frequency switching method of the local oscillator of the third embodiment is the same as those of the first and second embodiments except that no frequency multiplication is carried out.

With the local oscillator and its frequency switching method of the third embodiment, the same effects as those in the first and second embodiments can be obtained. Besides, there is an additional advantage that a circuit configuration of the local oscillator is simpler than that of the second embodiment since no frequency multiplier is required.

### [Fourth Embodiment]

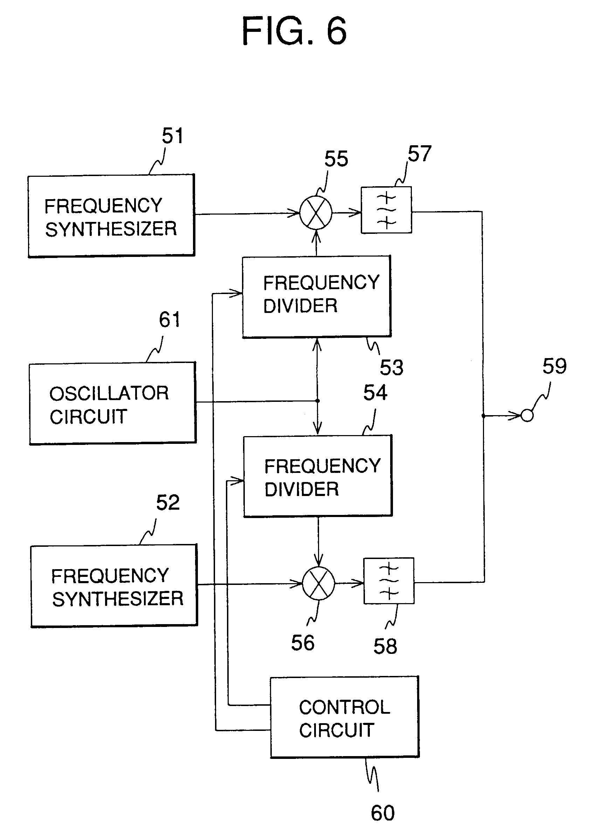

As shown in Fig. 6, a local oscillator for an RF communication system according to a fourth embodiment of the present invention is composed of first and second PLL frequency synthesizers 51 and 52, an oscillator circuit 61, first and second frequency dividers 53 and 54, a control circuit 60 for controlling the first and second frequency dividers 53 and 54, first and second frequency multipliers 55 and 56, and first and second bandpass filters 57 and 58.

The first PLL frequency synthesizer 51 generates a signal with a variable frequency f₁' to send it to the first frequency multiplier 55. The second PLL frequency synthesizer 52 generates a signal with a variable frequency f₂' to send it to the second frequency multiplier 56. These frequencies f₁' and f₂' are different from each other and belong to the same band of frequencies.

The oscillator circuit 61 generates a signal with a fixed frequency kf₀ which is k times in value as much as a frequency f₀ to send it to both of the first and second frequency dividers 53 and 54, where k is an integer of two (2) or more.

The frequencies f₁', f₂' and f₀ are in the following relationship: The sum or difference between the frequencies f₁' and f₀ are equal in value to a local frequency, and the sum or difference between the frequencies f₂' and f₀ are equal in value to another local frequency.

The first frequency divider 53 receives the output signal with the frequency kf₀ from the oscillator circuit 61 and divides it in frequency by a divide ratio k; then sends an output signal with the frequency f₀ thus obtained to the first frequency mixer 55. Similarly, the second frequency divider 55 receives the output signal with the frequency kf₀ from the oscillator circuit 61 and divides it in frequency by the same divide ratio k; then sends an output signal with the frequency f₀ thus obtained to the second frequency mixer 56.

The control circuit 60 controls the frequency dividers 53 and 54 so that one of the dividers 53 and 54 is in operation and the other is out of operation. Different from those in the first to third embodiments, the first or second divider 53 or 54 which is out of operation or stops operating does not output any signal to the corresponding one of the first and second frequency mixers 55 and 56.

The first frequency mixer 55 receives the output signal with the variable frequency f₁' from the first synthesizer 51 and the output signal with the fixed frequency f₀ from the first divider 53, and then mixes them in frequency with each other to send an output signal thus mixed to the first bandpass filter 57. Therefore, the output signal from the first frequency mixer 55 contains the components with the sum (f₁' + f₀) and the difference |f₁' - f₀| of the two frequencies f₁' and f₀.

Similarly, the second frequency mixer 56 receives the output signal with the variable frequency f₂' from the second synthesizer 52 and the output signal with the fixed frequency f₀ from the second divider 54, and mixes them in frequency with each other to send an output signal thus mixed to the second bandpass filter 58. Therefore, the output signal from the second frequency mixer 56 contains the components with the sum (f₂' + f₀) and the difference |f₂' - f₀| of the two frequencies f₂' and f₀.

The first bandpass filter 57 has a passband in which the component with the sum frequency (f₁' + f₀) or the difference frequency |f₁' - f₀| in the output signal from the first mixer 55 is selectively transmitted, so that one of the sum and difference frequencies is sent to an output terminal 59 as a local signal with a desired frequency.

Similarly, the second bandpass filter 58 has a passband in which the component with the sum frequency (f₂' + f₀) or the difference frequency |f₂' - f₀| in the output signal from the second mixer 56 is selectively transmitted, so that one of the sum and difference frequencies is sent to an output terminal 59 as a local signal with another desired frequency.

With the local oscillator of the fourth embodiment, local frequency switching is carried out as follows:

First, when a local signal is taken out through the first filter 57, the first frequency divider is put into operation by the control circuit 60, and the second frequency divider 54 does not operate.

The signal with the fixed frequency kf₀ generated in the oscillator 61 is divided in frequency by k in the first frequency divider 53 to be sent to the first frequency mixer 55 with the frequency being changed to f₀. The first frequency mixer 55 mixes in frequency the output signal with the frequency f₀ from the first divider 53 and that with the frequency f₁' from the first synthesizer 51 with each other thereby to generate an output signal containing the components with the sum frequency (f₁' + f₀) and the difference frequency |f₁' - f₀|, which is sent to the first bandpass filter 57.

If the sum frequency (fₗ' + f₀) is equal the local frequency, the first bandpass filter 57 selectively transmits the signal component with the sum frequency to the output terminal 59. If the difference frequency |f₁' - f₀| is equal to the local frequency, it selectively transmits the signal component with the difference frequency to the output terminal 59.

Here, since the second frequency divider 54 is not put into operation, no signal is outputted from the second frequency divider 54. Therefore, only the output signal with the frequency f₂' from the second frequency synthesizer 52 is inputted to the second frequency mixer 56. Then the second frequency mixer 56 sends an output signal containing only the component with the frequency f₂' to the second filter 58. The frequency f₂' is in outside of the passband of the filter 58, so that the output signal cannot pass through the filter 58, and as a result, no signal is outputted to the output terminal 59.

Thus, an output signal with a desired local frequency (f₁' + f₀) or |f₁' - f₀| can be obtained.

Similarly, when a local signal is taken out through the second filter 58, only the second frequency divider is put into operation by the control circuit 60.

The signal with the fixed frequency kf₀ generated in the oscillator 61 is divided by k in the second frequency divider 54 to be sent to the second frequency mixer 56 with the frequency being changed to f₀. The second frequency mixer 56 mixes the output signal with the frequency f₀ and that with the frequency f₂' from the second synthesizer 52 with each other to generate an output signal containing the components with the sum frequency (f₂' + f₀) and the difference frequency |f₂' - f₀|, which is sent to the second bandpass filter 58.

Similar to the first bandpass filter 57, the signal component with the sum frequency (f₂' + f₀) or with the difference frequency |f₂' - f₀| is selectively transmitted to the output terminal 59 as a local frequency.

Because no signal is outputted from the first frequency divider 53, no signal is outputted to the output terminal 59 through the first bandpass filter 57. Thus, an output signal with a local frequency (f₂' + f₀) or |f₂' - f₀| can be taken out from the terminal 59.

As described above, with the local oscillator of the fourth embodiment, the spurious component is sent from the first or second frequency divider 53 or 54 which is not in operation. The frequency of the spurious component is kf₀ which is k times as much as that required for generating local frequencies, or f₀. Therefore when the frequency kf₀ is mixed with the frequency f₁' or f₂' of the output signal from the first or second synthesizer 51 or 52 in the corresponding frequency mixer, its output frequency becomes |f₁' ± kf₀| or |f₂' ± kf₀|.

The frequencies |f₁' ± kf₀| and |f₂' ± kf₀| can be easily removed by the corresponding filter 57 or 58, respectively, by setting the respective passbands of the filters 57 and 58 so that the spurious frequencies |f₁' ± kf₀| and |f₂' ± kf₀| are outside of their passbands, respectively.

In Fig. 6, the output ends of the first and second filters 57 and 58 are connected directly to the output end 59, however, it is preferable that the output ends of the filters 57 and 58 are connected through a switch circuit composed of pin diodes or the like or a hybrid transformer, practically.

With the local oscillator and its frequency switching method of the fourth embodiment, the same effects as those in the first to third embodiments can be obtained.

In the first to fourth embodiments, there are provided wit two PLL frequency synthesizers, however, three or more synthesizers and their related elements such as frequency dividers and filters may be provided as occasion demands.

Thus to summarise, there is disclosed a local oscillator and its frequency switching method, in which local signals with less spurious components can be obtained. There are provided with frequency generators for generating signals with different frequencies and frequency dividers respectively connected to the generators. The dividers divide in frequency the signals to output them in an active mode, and output the signals without division in inactive mode. The dividers are controlled so that one of the dividers is in the active mode and the rest is in inactive mode. The output signals from the dividers are combined with each other to form a single output current and then is sent to a filter. The filter selects a component with a desired local frequency from the single output signal. Spurious components due to unselected frequencies are removed by the filter since they are not divided.

## Claims

1. A local oscillator for an RF communication system, comprising:
frequency generators (31;32;31a,31b) for generating signals, said signals being different in frequency from each other;
combining means (37;41) for combining signals with each other to generate a single output signal; and
a filter (38) for selecting a component from said single output signal from said combining means (37;41) thereby obtaining a desired local signal at an output end (39) of said filter;
characterised in that said oscillator further comprises:
frequency dividers (33,34) each respectively connected to a corresponding frequency generator (31,32;31a,31b) and receiving an output signal from said corresponding frequency generator;
each of said frequency dividers (33,34) having an active operation mode and an inactive operation mode, and in said active operation mode, dividing in frequency said output signal from said corresponding frequency generator (31,32;31a,31b) by a divide ratio n, where n is an integer of two or more, to output a resulting frequency-divided signal, and in said inactive operation mode, outputting said output signal without division;
said oscillator further comprising control means (40) for controlling said frequency dividers so that one of said frequency dividers is in said active operation mode and the or each of the others is in said inactive mode;
said combining means combining signals outputted from all of said frequency dividers (33,34) with each other to generate said single output signal;
said filter (38) selecting a component with a divided frequency from said single output signal to obtain said desired local signal.

2. A local oscillator as claimed in Claim 1, further comprising frequency multipliers (35,36) provided between said respective frequency dividers (33,34) and said combining means (37), said multipliers (35,36) multiplying in frequency each of said output signals from said frequency dividers (35,36) by a multiplication ratio m, m is an integer of two or more and sending said output signal thus multiplied to said combining means (37).

3. A local oscillator as claimed in Claim 1, further comprising a frequency multiplier (42) provided between said combining means (37) and said filter (38), said multiplier (42) multiplying in frequency said single output signal from said combining means (37) by a multiplication ratio m, m is an integer of two or more and sending said output signal thus multiplied to said filter (38).

4. A local oscillator as claimed in Claim 2 or Claim 3, wherein said multiplication ratio m is smaller in value than said divide ratio n, and said filter (38) stops signal components having frequencies equal to or greater than n/m times the frequencies of the signals output from said frequency generators (31,32).

5. A local oscillator for an RF communication system, comprising:
an oscillator (61) generating a first signal with a fixed frequency of k times a given frequency, where k is an integer of two or more; and
frequency generators (51,52) for generating second signals, said second signals being different in frequency from each other;
characterised in that the oscillator further comprises:
frequency dividers (53,54) respectively connected to said oscillator (61), each of said frequency dividers (53,54) receiving said first signal from said oscillator (61) and dividing in frequency said first signal by a divide ratio of k;
control means for controlling said frequency dividers (53,54) so that one of said frequency dividers (53,54) is in operation and the or each of the remainder is out of operation;
frequency mixers (55,56) each of which mixes in frequency an output signal from a corresponding one of said frequency dividers (53,54) with said second signal from a corresponding one of said frequency generators (51,52);
filters (57,58) respectively connected to said frequency mixers (55,56), each of which selects a component with a desired local frequency from an output signal of a corresponding one of said frequency mixers (55,56); and
an output terminal (59) connected to all of said filters;
and wherein said component with said desired local frequency is derived through the one of said filters (57,58) corresponding to the operating one of said frequency dividers (53,54).

6. A frequency switching method of a local oscillator for an RF communication system, said method comprising the steps of:
generating signals different in frequency by using frequency generators (31,32;31a,31b);
and characterised by further comprising the steps of
dividing in frequency one of said signals by a divide ratio n, n is an integer of two or more, by controlling frequency dividers (33,34) respectively connected to said frequency generators so that one of said frequency dividers (31,32) is in an active operation mode, thereby outputting a resulting frequency-divided signal and the or each of the others is in an inactive operation mode, thereby outputting one or more output signals without division;
combining said output signal from one of said frequency dividers which is in an active operation mode and said output signal or output signals from the or each of the remainder of said frequency dividers which is in an inactive operation mode with each other, thereby generating a single output signal; and
selecting by using a filter (38) a component with a frequency obtained through said dividing step from said single output signal of said combining means (37;41) as a local signal.

7. A frequency switching method as claimed in Claim 6, wherein said output signals from said frequency dividers (33,34) are sent to said combining means (37) after multiplying in frequency by a multiplication ratio m, m is an integer of two or more, using frequency multipliers (31,32) provided between said respective frequency dividers and said combining means.

8. A frequency switching method as claimed in Claim 6, wherein said single output signal from said combining means (37) is sent to said filter (38) after multiplying in frequency by a multiplication ratio m, m is an integer of two or more, by using a frequency multiplier (42) provided between said combining means (37) and said filter (38).

9. A frequency switching method of a local oscillator comprising the steps of:
generating a first signal with a fixed frequency of k times a given frequency by using an oscillator (61), where k is an integer of two or more;
generating second signals with different frequencies by using frequency generators (51,52);
characterised by further comprising the steps of:
dividing in frequency said first signal by a divide ratio k by using frequency dividers (53,54), said frequency dividers (53,54) being connected to said oscillator (61) and being controlled so that one of said frequency dividers (53,54) is in operation thereby outputting a frequency divider signal and the or each of the remainder is out of operation, thereby outputting said first signal without division;
mixing in frequency by using frequency mixers (55,56) said output signals from said frequency dividers (53,54) with said second signals from said corresponding frequency generators (51,52), respectively; and
selecting by using filters (57,58) a component with a desired local frequency from said respective output signals of said frequency mixers (55,56), said filters (57,58) being respectively connected to said frequency mixers (55,56);
wherein said component with said desired local frequency is derived through one of said filters (57,58) corresponding to the operating one of said frequency dividers (53,54).

## Patentansprüche

1. Überlagerungsoszillator für ein RF-Informationsaustauschsystem, der aufweist:
Frequenzgeneratoren (31, 32; 31a, 31b) zum Erzeugen von Signalen, wobei die Signale frequenzmäßig voneinander verschieden sind;
Vereinigungsmittel (37; 41) zum Vereinigen von Signalen miteinander, um ein einziges Ausgangssignal zu erzeugen; und
einen Filter (38) zum Auswählen einer Komponente aus dem einzigen Ausgangssignal von den Vereinigungsmitteln (37; 41), wobei dadurch ein gewünschtes Überlagerungssignal am Ausgangsende (39) des Filters erhalten wird;
dadurch gekennzeichnet, daß der Oszillator weiter aufweist:
Frequenzteiler (33, 34), die jeweils mit einem entsprechenden Frequenzgenerator (31, 32; 31a, 31b) verbunden sind und ein Ausgangssignal von dem entsprechenden Frequenzgenerator empfangen;
wobei jeder der Frequenzteiler (33, 34) eine aktive Betriebsart und eine inaktive Betriebsart aufweist und in der aktiven Betriebsart frequenzmäßig das Ausgangssignal vom entsprechenden Frequenzgenerator (31, 32; 31a, 31b) durch ein Teilungsverhältnis n teilt, wobei n eine ganze Zahl von zwei oder mehr ist, um ein resultierendes frequenzgeteiltes Signal auszugeben, und in der inaktiven Betriebsart das Ausgangssignal ohne Teilung ausgibt;
wobei der Oszillator weiter Steuermittel (40) zum Steuern der Frequenzteiler aufweist, so daß einer der Frequenzteiler sich in der aktiven Betriebsart und der andere oder die anderen sich in der inaktiven Betriebsart befinden;
wobei die Vereinigungsmittel Signale vereinigen, die von allen Frequenzteilern (33, 34) ausgegeben werden, um das einzige Ausgangssignal zu erzeugen;
wobei der Filter (38) eine Komponente mit einer geteilten Frequenz von dem einzigen Ausgangssignal auswählt, um das gewünschte Überlagerungssignal zu erhalten.

2. Überlagerungsoszillator nach Anspruch 1, der weiter Frequenzvervielfacher (35, 36) aufweist, die zwischen den entsprechenden Frequenzteilern (33, 34) und den Vereinigungsmitteln (37) vorgesehen sind, wobei die Vervielfacher (35, 36) frequenzmäßig jedes der Ausgangssignale von den Frequenzteilern (35, 36) mit einem Vervielfachungsverhältnis m vervielfachen (m ist eine ganze Zahl von zwei oder mehr), und das so vervielfachte Ausgangssignal zu den Vereinigungsmitteln (37) schicken.

3. Überlagerungsoszillator nach Anspruch 1, der weiter einen Frequenzvervielfacher (42) aufweist, der zwischen den Vereinigungsmitteln (37) und dem Filter (38) vorgesehen ist, welcher Vervielfacher (42) frequenzmäßig das einzige Ausgangssignal von den Vereinigungsmitteln (37) mit einem Vervielfachungsverhältnis m (m ist eine ganze Zahl von zwei oder mehr) vervielfacht und das so vervielfachte Ausgangssignal zu dem Filter (38) schickt.

4. Überlagerungsoszillator nach Anspruch 2 oder 3, bei dem das Vervielfachungsverhältnis m kleiner im Wert ist als das Teilungsverhältnis n und bei dem der Filter (38) Komponenten mit Frequenzen sperrt, die gleich sind oder größer als n/m-mal die Frequenzen der Signale, die von den Frequenzgeneratoren (31, 32) ausgegeben werden.

5. Überlagerungsoszillator für ein RF-Informationsaustauschsystem, der aufweist:
einen Oszillator (61), der ein erstes Signal mit einer festen Frequenz von k mal einer vorgegebenen Frequenz erzeugt, wobei k eine ganze Zahl von zwei oder mehr ist; und
Frequenzgeneratoren (51, 52) zum Erzeugen zweiter Signale, wobei die zweiten Signale frequenzmäßig voneinander verschieden sind;
dadurch gekennzeichnet, daß der Oszillator weiter aufweist:
Frequenzteiler (53, 54), die mit dem Oszillator (61) verbunden sind, wobei jeder der Frequenzteiler (53, 54) das erste Signal vom Oszillator (61) empfängt und dieses erste Signal frequenmäßig mit einem Teilungsverhältnis k teilt;
Steuermittel zum Steuern der Frequenzteiler (53, 54), so daß einer der Frequenzteiler (53, 54) in Betrieb ist und der übrige bzw. die übrigen außer Betrieb sind;
Frequenzmischer (55, 56), von denen jeder frequenzmäßig ein Ausgangssignal von einem entsprechenden der Frequenzteiler (53, 54) mit dem zweiten Signal von einem entsprechenden der Frequenzgeneratoren (51, 52) mischt;
Filter (57, 58), die mit dem Frequenzmischern (55, 56) verbunden sind, von denen jeder eine Komponente mit einer gewünschten Überlagerungsfrequenz aus einem Ausgangssignal eines entsprechenden der Frequenzmischer (55, 56) auswählt; und
einen Ausgangsanschluß (59), der mit allen Filtern verbunden ist;
und wobei die Komponente mit der gewünschten Überlagerungsfrequenz durch einen der Filter (57, 58), der dem in Betrieb befindlichen der Frequenzteiler (53, 54) entspricht, abgeleitet wird.

6. Frequenzschaltverfahren eines Überlagerungsoszillators für ein RF-Informationsaustauschsystem, welches Verfahren die Schritte aufweist:
Signale mit unterschiedlicher Frequenz unter Verwendung von Frequenzgeneratoren (31,32; 31a, 31b) zu erzeugen;
und dadurch gekennzeichnet ist, daß es weiter die Schritte aufweist:
frequenzmäßig eines der Signale mit einem Teilungsverhältnis n (n ist eine ganze Zahl von zwei oder mehr) zu teilen, indem Frequenzteiler (33, 34) gesteuert werden, die mit den Frequenzgeneratoren verbunden sind, so daß einer der Frequenzteiler (31, 32) in einer aktiven Betriebsart ist und dabei ein resultierendes frequenzgeteiltes Signal abgibt und der andere oder die anderen in einer inaktiven Betriebsart sind, wobei sie dabei ein oder mehrere Ausgangssignale ohne Teilung ausgeben;
das Ausgangssignal von einem der Frequenzteiler, der sich in der aktiven Betriebsart befindet, und das Ausgangssignal oder die Ausgangssignale von dem oder den übrigen der Frequenzteiler, der bzw. die sich in einer inaktiven Betriebsart befinden, miteinander zu mischen, wodurch ein einziges Ausgangssignal erzeugt wird; und
unter Verwendung eines Filters (38) eine Komponente mit einer Frequenz als Überlagerungssignal auszuwählen, die durch den Teilungsschritt von dem einzigen Ausgangssignal des Vereinigungsmittels (37; 41) erhalten wird.

7. Frequenzschaltverfahren nach Anspruch 6, bei dem die Ausgangssignale der Frequenzteiler (33, 34) zu dem Vereinigungsmittel (37) nach Frequenzvervielfachung um ein Vervielfachungsverhältnis m (m ist eine ganze Zahl von zwei oder mehr) zu schicken, wobei Frequenzvervielfacher (31, 32) verwendet werden, die zwischen den entsprechenden Frequenzteilern und dem Vereinigungsmittel vorgesehen sind.

8. Frequenzschaltverfahren nach Anspruch 6, bei dem das einzige Ausgangssignal von dem Vereinigungsmittel (37) zum Filter (38) nach Frequenzvervielfachung um ein Vervielfachungsverhältnis m (m ist eine ganze Zahl von zwei oder mehr) geschickt wird, wobei ein Frequenzvervielfacher (42) verwendet wird, der zwischen dem Vereinigungsmittel (37) und dem Filter (38) vorgesehen ist.

9. Frequenzschaltverfahren eines Überlagerungsoszillators, das die Schritte aufweist:
ein erstes Signal mit einer festen Frequenz unter Verwendung eines Oszillators (61) zu erzeugen, die k mal einer vorgegebenen Frequenz ist, wobei k eine ganze Zahl von zwei oder mehr ist;
zweite Signale mit unterschiedlichen Frequenzen unter Verwendung von Frequenzgeneratoren (51, 52) zu erzeugen;
dadurch gekennzeichnet, daß es weiter die Schritte aufweist:
frequenzmäßig das erste Signal durch ein Teilungsverhältnis k unter Verwendung von Frequenzteilern (53, 54) zu teilen, wobei die Frequenzteiler (53, 54) mit dem Oszillator (61) verbunden sind und so gesteuert werden, daß einer der Frequenzteiler (53, 54) in Betrieb ist und dabei ein Frequenzteilersignal ausgibt und der übrige oder die übrigen außer Betrieb sind und dabei das erste Signal ohne Teilung ausgeben;
frequenzmäßig unter Verwendung von Frequenzmischern (55, 56) die Ausgangssignale von den Frequenzteilern (53, 54) mit den zweiten Signalen von den entsprechenden Frequenzgeneratoren (51, 52) zu mischen; und
unter Verwendung von Filtern (57, 58) eine Komponente mit der gewünschten Überlagerungsfrequenz aus den Ausgangssignalen der Frequenzmischer (55, 56) auszuwählen, wobei die Filter (57, 58) mit den Frequenzmischern (55, 56) verbunden sind;
wobei die Komponente mit der gewünschten Überlagerungsfrequenz durch einen der Filter (57, 58), der dem in Betrieb befindlichen der Frequenzteiler (53, 54) entspricht, abgeleitet wird.

## Revendications

1. Oscillateur local pour un système de communication radiofréquence, comprenant :
des générateurs de fréquence (31 ; 32 ; 31a, 31b) pour générer des signaux, lesdits signaux ayant des fréquences qui diffèrent les unes des autres ;
des moyens de combinaison (37 ; 41) pour combiner des signaux les uns aux autres afin de générer un signal de sortie unique ; et
un filtre (38) pour sélectionner une composante à partir dudit signal de sortie unique provenant desdits moyens de combinaison (37 ; 41) obtenant ainsi un signal local désiré à une borne de sortie (39) dudit filtre ;
caractérisé en ce que ledit oscillateur comprend en outre :
des diviseurs de fréquence (33, 34) connectés respectivement chacun à un générateur de fréquence correspondant (31, 32 ; 31a, 31b) et recevant un signal de sortie provenant dudit générateur de fréquence correspondant ;
chacun desdits diviseurs de fréquence (33, 34) ayant un mode opératoire actif et un mode opératoire inactif, et dans ledit mode opératoire actif, divisant en fréquence ledit signal de sortie provenant dudit générateur de fréquence correspondant (31, 32 ; 31a, 31b) par un rapport de division n, dans lequel n est un entier égal ou supérieur à deux, afin de délivrer un signal divisé en fréquence résultant, et, dans ledit mode opératoire inactif, délivrant ledit signal de sortie sans division ;
ledit oscillateur comprenant en outre des moyens de commande (40) pour commander lesdits diviseurs de fréquence de telle sorte que l'un desdits diviseurs de fréquence est dans ledit mode opératoire actif et les autres ou chacun des autres sont dans ledit mode inactif ;
lesdits moyens de combinaison combinant des signaux délivrés par tous lesdits diviseurs de fréquence (33, 34) les uns avec les autres afin de générer ledit signal de sortie unique ;
ledit filtre (38) sélectionnant une composante avec une fréquence divisée à partir dudit signal de sortie unique afin d'obtenir ledit signal local désiré.

2. Oscillateur local selon la revendication 1, comprenant en outre des multiplicateurs de fréquence (35, 36) placés entre lesdits diviseurs de fréquence respectifs (33, 34) et lesdits moyens de combinaison (37), lesdits multiplicateurs (35, 36) multipliant en fréquence chacun desdits signaux de sortie provenant desdits diviseurs de fréquence (35, 36) par un rapport de multiplication m, (m est un entier égal ou supérieur à deux), et transmettant ledit signal de sortie ainsi multiplié auxdits moyens de combinaison (37).

3. Oscillateur local selon la revendication 1, comprenant en outre un multiplicateur de fréquence (42) placé entre lesdits moyens de combinaison (37) et ledit filtre (38), ledit multiplicateur (42) multipliant en fréquence ledit signal de sortie unique provenant desdits moyens de combinaison (37) par un rapport de multiplication m, (m est un entier égal ou supérieur à deux) et transmettant ledit signal de sortie ainsi multiplié audit filtre (38).

4. Oscillateur local selon la revendication 2 ou 3, dans lequel ledit rapport de multiplication m a une valeur inférieure audit rapport de division n, et ledit filtre (38) bloque les composantes du signal ayant des fréquences égales ou supérieures à n/m fois les fréquences des signaux délivrés par lesdits générateurs de fréquence (31,32).

5. Oscillateur local pour un système de communication radiofréquence, comprenant :
un oscillateur (61) générant un premier signal avec une fréquence fixe de k fois une fréquence donnée, k étant un entier égal ou supérieur à deux ; et
des générateurs de fréquence (51, 52) pour générer des seconds signaux, lesdits seconds signaux ayant des fréquences qui diffèrent les unes des autres ;
caractérisé en ce que l'oscillateur comprend en outre :
des diviseurs de fréquence (53, 54) respectivement connectés audit oscillateur (61), chacun desdits diviseurs de fréquence (53, 54) recevant ledit premier signal provenant dudit oscillateur (61) et divisant en fréquence ledit premier signal par un rapport de division k ;
des moyens de commande pour commander lesdits diviseurs de fréquence (53, 54) de telle sorte que l'un desdits diviseurs de fréquence (53, 54) est en mode opératoire et les ou chacun des diviseurs restants ne sont pas en mode opératoire ;
des mélangeurs de fréquence (55, 56), chacun d'entre eux mélangeant en fréquence un signal de sortie provenant de l'un correspondant desdits diviseurs de fréquence (53, 54) avec ledit second signal provenant de l'un, correspondant, desdits générateurs de fréquence (51, 52) ;
des filtres (57, 58) respectivement connectés auxdits mélangeurs de fréquence (55, 56), chacun d'entre eux sélectionnant une composante ayant une fréquence locale désirée à partir d'un signal de sortie d'un, correspondant, desdits mélangeurs de fréquence (55, 56) ; et
une borne de sortie (59) connectée à tous lesdits filtres ;
et dans lequel ladite composante ayant ladite fréquence locale désirée est dérivée par l'un desdits filtres (57, 58) correspondant à celui, en mode opératoire, desdits diviseurs de fréquence (53, 54).

6. Procédé de commutation de fréquence d'un oscillateur local pour un système de communication haute fréquence, ledit procédé comprenant les étapes consistant :
à générer des signaux ayant des fréquences qui diffèrent en utilisant des générateurs de fréquences (31, 32 ; 31a, 31b) ;
et caractérisé en ce qu'il comprend en outre les étapes consistant
à diviser en fréquence l'un desdits signaux par un rapport de division n, (n est un entier égal ou supérieur à deux), en commandant des diviseurs de fréquence (33, 34) respectivement connectés auxdits générateurs de fréquence de sorte que l'un desdits diviseurs de fréquence (31, 32) est en mode opératoire actif, délivrant ainsi un signal divisé en fréquence résultant et les ou chacun des autres est en mode opératoire inactif, délivrant ainsi un ou plusieurs signaux de sortie sans division ;
à combiner ledit signal de sortie provenant de l'un desdits diviseurs de fréquence qui est en mode opératoire actif et audit signal de sortie ou auxdits signaux de sortie provenant du ou de chacun des diviseurs restants desdits diviseurs de fréquence qui sont en mode opératoire inactif les uns avec les autres, générant ainsi un signal de sortie unique ; et
à sélectionner en utilisant un filtre (38) une composante ayant une fréquence obtenue par ladite étape de division à partir dudit signal de sortie unique desdits moyens de combinaison (37 ; 41) en tant que signal local.

7. Procédé de commutation de fréquence selon la revendication 6, dans lequel lesdits signaux de sortie provenant desdits diviseurs de fréquence (33, 34) sont transmis auxdits moyens de combinaison (37) après multiplication en fréquence par un rapport de multiplication m, (m est un entier égal ou supérieur à deux), en utilisant des multiplicateurs de fréquence (31, 32) placés entre lesdits diviseurs de fréquence respectifs et lesdits moyens de combinaison.

8. Procédé de commutation de fréquence selon la revendication 6, dans lequel ledit signal de sortie unique provenant desdits moyens de combinaison (37) est transmis audit filtre (38) après multiplication en fréquence par un rapport de multiplication m, (m est un entier égal ou supérieur à deux), en utilisant un multiplicateur de fréquence (42) placé entre lesdits moyens de combinaison (37) et ledit filtre (38).

9. Procédé de commutation de fréquence d'un oscillateur local, comprenant les étapes consistant :
à générer un premier signal ayant une fréquence fixe égale à k fois une fréquence donnée en utilisant un oscillateur (61), k étant un entier égal ou supérieur à deux ;
à générer des seconds signaux ayant des fréquences différentes en utilisant des générateurs de fréquences (51, 52) ;
caractérisé en ce qu'il comprend en outre les étapes consistant :
à diviser en fréquence ledit premier signal par un rapport de division k en utilisant des diviseurs de fréquence (53, 54), lesdits diviseurs de fréquence (53, 54) étant connectés audit oscillateur (61) et étant commandés de telle sorte que l'un desdits diviseurs de fréquence (53, 54) est en mode opératoire et délivrant ainsi un signal de diviseur de fréquence et les ou chacun des diviseurs restants ne sont pas en mode opératoire, délivrant ainsi ledit premier signal sans division ;
à mélanger en fréquence en utilisant des mélangeurs de fréquences (55, 56) lesdits signaux de sortie provenant desdits diviseurs de fréquence (53, 54) auxdits seconds signaux provenant desdits générateurs de fréquence correspondants (51, 52), respectivement ; et
à sélectionner en utilisant des filtres (57, 58) une composante ayant une fréquence locale désirée à partir desdits signaux de sortie respectifs desdits mélangeurs de fréquence (55, 56), lesdits filtres (57, 58) étant respectivement connectés auxdits mélangeurs de fréquence (55, 56) ;
dans lequel ladite composante ayant ladite fréquence locale désirée est dérivée par l'un desdits filtres (57, 58) correspondant à celui, en mode opératoire, desdits diviseurs de fréquence (53, 54).
